(19) Europäisches Patentamt / European Patent Office / Office européen des brevets

(11) **EP 4 015 901 B1**

(12) **FASCICULE DE BREVET EUROPEEN**

(45) Date de publication et mention
de la délivrance du brevet:
**30.08.2023 Bulletin 2023/35**

(21) Numéro de dépôt: **21214758.1**

(22) Date de dépôt: **15.12.2021**

(51) Classification Internationale des Brevets (IPC):
**F21V 15/00** *(2015.01)*    **G01R 19/17** *(2006.01)*
**F21W 131/103** *(2006.01)*

(52) Classification Coopérative des Brevets (CPC):
**G01R 19/17;** F21W 2131/103

(54) **MODULE D'ALIMENTATION ÉLECTRIQUE POUR INSTALLATION D'ÉCLAIRAGE PUBLIC, LAMPADAIRE COMPRENANT UN TEL MODULE D'ALIMENTATION ET INSTALLATION D'ÉCLAIRAGE PUBLIC COMPRENANT AU MOINS UN TEL LAMPADAIRE**

STROMVERSORGUNGSMODUL FÜR EINE STRASSENBELEUCHTUNGSANLAGE, STRASSENLAMPE MIT EINEM SOLCHEN VERSORGUNGSMODUL UND STRASSENBELEUCHTUNGSANLAGE MIT MINDESTENS EINER SOLCHEN STRASSENLAMPE

POWER SUPPLY MODULE FOR A PUBLIC LIGHTING INSTALLATION, LAMP COMPRISING SUCH A POWER SUPPLY MODULE AND PUBLIC LIGHTING INSTALLATION COMPRISING AT LEAST ONE SUCH LAMP

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.12.2020 FR 2013380**

(43) Date de publication de la demande:
**22.06.2022 Bulletin 2022/25**

(73) Titulaire: **Lacroix Group
44800 Saint Herblain (FR)**

(72) Inventeurs:
• **GRELOT, David
69400 VILLEFRANCHE SUR SAONE (FR)**
• **HUOT, Laurent
69890 LA TOUR DE SALVAGNY (FR)**

(74) Mandataire: **Lavoix
62, rue de Bonnel
69448 Lyon Cedex 03 (FR)**

(56) Documents cités:
**WO-A1-2015/149210     CN-U- 202 797 953**

**Description**

La présente invention concerne un module d'alimentation électrique pour installation d'éclairage public, un lampadaire comprenant un tel module d'alimentation et une installation d'éclairage public comprenant au moins un tel lampadaire.

Le document WO-A-2015 149210 décrit une lampe LED comprenant une source lumineuse et un circuit électronique comportant un condensateur de dérivation haute tension, qui protège la source lumineuse en cas de surtension. Un état de la technique pertinent est aussi divulgué dans le document CN202797953U.

Dans le domaine de l'éclairage public, il est connu d'alimenter électriquement un lampadaire bénéficiant d'une isolation électrique de classe II à l'aide d'un module d'alimentation électrique, également appelé driver. Ce module, installé dans le lampadaire, est relié à un poste d'alimentation électrique distant du lampadaire et ne possède pas de connexion à la terre. Il arrive que des impacts de foudre tombant au voisinage du lampadaire provoquent des phénomènes de surtension de mode commun qui peuvent endommager ou accélérer le vieillissement du module d'alimentation électrique ou d'autres composants du lampadaire. Il est donc souhaitable de pouvoir compter les occurrences de tels phénomènes de surtension, sans avoir à recourir à la mise en oeuvre de modules supplémentaires, afin de pouvoir les prendre en compte dans la maintenance du lampadaire.

C'est à cet inconvénient qu'entend plus particulièrement remédier l'invention en proposant un module d'alimentation électrique pour installation d'éclairage public configuré pour détecter et compter les impacts de foudre se produisant au voisinage d'un lampadaire.

À cet effet, l'invention concerne un module d'alimentation électrique pour une installation d'éclairage public, ce module d'alimentation possédant une isolation électrique de classe II, ce module d'alimentation électrique comprenant :

- des bornes d'entrées configurées pour être raccordées à un conducteur de phase et un conducteur de neutre provenant d'un poste d'alimentation électrique raccordé à un premier point de terre électrique ;
- des bornes de sortie configurées pour être raccordées à un module d'éclairage ;
- un convertisseur de tension et de courant alternatif / continu, raccordé entre les bornes d'entrées et les bornes de sortie du module d'alimentation, définissant un circuit primaire et un circuit secondaire isolés galvaniquement ; et
- un condensateur de filtrage connecté entre un point référencé au circuit primaire du convertisseur et un point référencé au circuit secondaire du convertisseur.

Grâce à l'invention, le module d'alimentation électrique comporte en outre :

- un circuit de détection ; et
- un compteur connecté aux bornes de sortie du circuit de détection,

le circuit de détection comportant :

- un capteur configuré pour :

  ○ mesurer un courant électrique circulant, en cas de surtension de mode commun entre des conducteurs actifs d'alimentation du module d'alimentation électrique et une terre de référence locale du module d'alimentation électrique, dans un bras du module d'alimentation comportant le condensateur de filtrage ; et
  ○ délivrer une tension de mesure représentative du courant mesuré,

- un étage de traitement configuré pour fournir, en cas de surtension, un signal de tension électrique redressé en sortie du circuit de détection à partir de la tension de mesure ;

le circuit de détection étant ainsi configuré pour détecter une surtension de mode commun, le compteur étant configuré pour compter le nombre d'évènements de surtension de mode commun à partir du signal de tension électrique de sortie du circuit de détection.

Grâce à l'invention, le module d'alimentation électrique pour installation d'éclairage public intègre un circuit électrique de détection des impacts de foudre et un compteur de ces impacts.

Selon des aspects avantageux, mais non obligatoire de l'invention, ce module d'alimentation électrique incorpore une ou plusieurs des caractéristiques suivantes, prises isolément ou selon toutes combinaisons techniquement admissibles :

- Le capteur du circuit de détection est une résistance.
- La résistance est connectée en série avec le condensateur de filtrage.
- Le capteur du circuit de détection est un transformateur de courant.
- L'étage de traitement comprend une première résistance montée en série entre une première borne d'entrée du capteur et la première borne de sortie du circuit de détection et une première diode montée en parallèle avec le compteur, la première diode étant une diode Zener, et les bornes de sortie du circuit de détection sont les bornes de la première diode.
- Le circuit de détection comprend un deuxième étage connecté en amont de l'étage de traitement, le deuxième étage comprenant une deuxième diode montée en série entre la première borne d'entrée du capteur et la première résistance, l'anode de la deuxième diode est reliée à la première borne du capteur et la cathode de la deuxième diode est reliée à la première résistance ; un premier condensateur monté en parallèle avec le capteur, une première borne du condensateur étant reliée à la cathode de la deuxième diode et une seconde borne du condensateur étant reliée à une seconde borne d'entrée du capteur ; et une deuxième résistance montée en parallèle avec le premier condensateur, et le deuxième étage est configuré pour transformer la tension de mesure de sorte que la décharge d'une tension aux bornes de la deuxième résistance soit plus lente que la décharge de la tension de mesure.

- Le circuit de détection comprend un troisième étage connecté en amont du deuxième étage, le troisième étage comprenant une troisième résistance montée en série entre la première borne d'entrée du capteur et la sortie du troisième étage ; un deuxième condensateur monté en parallèle de la troisième résistance ; et une troisième diode montée en parallèle de la sortie du troisième étage dont l'anode est reliée à la deuxième borne d'entrée du capteur et la cathode est reliée à la sortie du troisième étage, et le troisième étage de redressage est configuré pour que dans le cas d'une tension de mesure négative, la tension mesurée aux bornes de la deuxième résistance soit positive.

- La capacité du deuxième condensateur est au moins vingt-cinq fois supérieure à la capacité du premier condensateur.

Selon un autre aspect, l'invention concerne aussi un lampadaire comprenant

- au moins un module d'éclairage comportant au moins une source lumineuse telle qu'une diode électroluminescente ;
- un module d'alimentation électrique alimentant en courant continu le ou chaque module d'éclairage ; et
- un corps métallique contenant le ou chaque module d'éclairage et le module d'alimentation, le corps métallique étant raccordé électriquement à une terre de référence locale et isolé électriquement du module d'éclairage,

dans lequel le module d'alimentation électrique est tel que mentionné ci-dessus.

Selon un autre aspect, l'invention concerne aussi une installation d'éclairage public comprenant :

- un poste d'alimentation électrique connecté au module d'alimentation électrique par l'intermédiaire d'un conducteur de phase et d'un conducteur de neutre, le neutre étant connecté à une terre électrique locale au niveau du poste d'alimentation électrique ; et
- au moins un lampadaire tel que mentionné ci-dessus

et dans laquelle le module d'alimentation électrique de chaque lampadaire est configuré pour détecter une surtension de mode commun entre des conducteurs actifs d'alimentation du module d'alimentation électrique et le corps métallique du lampadaire et compter le nombre d'évènements de surtension de mode commun.

L'invention sera mieux comprise et d'autres avantages de celle-ci apparaitront plus clairement à la lumière de la description qui va suivre d'un mode de réalisation d'un module d'alimentation électrique ; d'un lampadaire comprenant un tel module d'alimentation et d'une installation d'éclairage public comprenant au moins un tel lampadaire, donnée uniquement à titre d'exemple et faite en référence aux dessins annexés dans lesquels :

[Fig. 1] La figure 1 est une représentation schématique d'un exemple d'une première installation d'éclairage public conforme à l'invention, comprenant un lampadaire et un module d'alimentation électrique conformes à des modes de réalisation de l'invention.
[Fig. 2] La figure 2 est une représentation schématique des circuits électriques de l'installation d'éclairage public de la figure 1.
[Fig. 3] La figure 3 est un détail d'un circuit de détection du module d'alimentation électrique de la figure 1.
[Fig. 4] La figure 4 regroupe les courbes représentatives de plusieurs grandeurs électriques du circuit électrique du module d'alimentation.
[Fig. 5] La figure 5 est une représentation schématique des circuits électriques d'une installation d'éclairage public conforme à une deuxième représentation de l'invention.

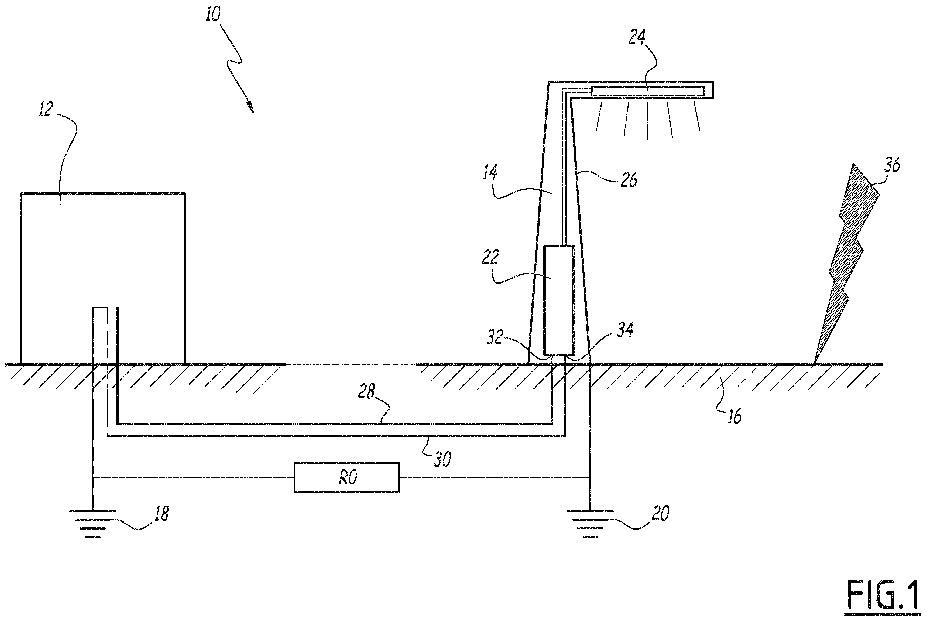

Un exemple d'une installation d'éclairage public 10 est représentée à la figure 1. Cette installation comprend un poste d'alimentation électrique 12 et un lampadaire 14, par exemple disposés sur un sol 16, ou sur une structure elle-même disposée sur le sol 16. Le sol 16 est généralement un conducteur d'électricité imparfait, c'est-à-dire que sa résistivité est non-nulle.
Le poste d'alimentation électrique 12 est relié à un premier point de terre électrique 18 et le lampadaire 14 est relié à un deuxième point de terre électrique 20. Le poste d'alimentation et le lampadaire sont distants l'un de l'autre, de sorte que les points de terre électrique 18 et 20 sont électriquement reliés par le sol 16 de résistivité non-nulle.
Le deuxième point de terre électrique 20 représente une terre de référence locale du lampadaire 14 et des composants que contient de lampadaire.
En pratique, le fait que le sol 16 ait une résistivité non-nulle permet d'assimiler le sol à une résistance équivalente, notée R0, montée en série entre les deux points de terre électrique 18 et 20. Généralement, cette résistance équivalente R0 dépend notamment de la nature du sol 16, et est proportionnelle à la distance qui sépare les points de terre électrique 18 et 20. En pratique, le coefficient de proportionnalité est compris entre 10 $\Omega$.m et 10 000 $\Omega$.m, et de préférence est égal à 500 $\Omega$.m.

Dans l'exemple représenté sur la figure 1, l'installation d'éclairage public 10 comporte un seul lampadaire 14. En pratique, une installation d'éclairage public peut comporter plusieurs lampadaires 14, qui par exemple chacun reliés à un deuxième point de terre électrique 20, qui leur est propre ou qui peut être commun à celui de lampadaires voisins, mais qui dans tous les cas est distinct du premier point de terre électrique 18, c'est-à-dire qu'ils sont tous distants du poste d'alimentation 12.

Le lampadaire 14 comprend un module d'alimentation électrique 22, au moins un module d'éclairage 24 et un corps métallique 26. Le module d'alimentation et le ou chaque module d'éclairage du lampadaire sont disposés dans le corps métallique.

Le module d'alimentation électrique 22 est alimenté en courant alternatif par le poste d'alimentation électrique 12, par l'intermédiaire d'un conducteur de phase 28 et d'un conducteur de neutre 30, qui sont par exemple enterrés dans le sol 16. En variante, on peut utiliser des câbles aériens. Les conducteurs de phase 28 et de neutre 30 forment ensemble des conducteurs actifs d'alimentation du module 22.

Les connecteurs de phase 28 et de neutre 30 sont respectivement connectés à une borne d'entrée de phase 32 et une borne d'entrée de neutre 34 du module d'alimentation.

Un aspect de l'invention vise plus particulièrement à détecter et à compter les occurrences de surtension de mode commun subies par un lampadaire 14 lors d'un impact de foudre 36 frappant le voisinage du lampadaire 14, par exemple lorsque la foudre frappe le sol 16. Au sens de la présente description, une surtension de mode commun, notée Usurge sur la figure 1, correspond à une différence de potentiel électrique entre le lampadaire 14 qui voit son potentiel électrique - par l'intermédiaire de celui du point de masse 20 auquel il est connecté - brutalement augmenter suite à l'impact de foudre 36 se produisant sur son voisinage, et le module d'alimentation 22 qui est électriquement connecté au point de masse 18 du poste électrique distant. En d'autres termes, l'impact de foudre 36 génère un courant d'une intensité très importante s'écoulant dans la terre, en pratique de plusieurs dizaines à plusieurs centaines de kilo ampères, ce qui conduit à une variation locale importante du potentiel de terre autour de son point d'impact.

En pratique, la surtension de mode commun Usurge se produit entre le deuxième point de terre électrique 20 et les conducteurs actifs du module d'alimentation 22.

L'impact de foudre 36 étant localisé à proximité du lampadaire 14, c'est-à-dire sur le deuxième point de terre électrique 20, il provoque une différence de potentiel entre le premier point de terre électrique 18 et le deuxième point de terre électrique 20, qui génère une onde de tension entre les deux points de terre. Cette surtension de mode commun est soit négative, c'est-à-dire que le potentiel du deuxième point de terre 20 est fortement abaissé par rapport au premier point de terre 18, soit positive, c'est-à-dire qu'à l'inverse le potentiel du deuxième point de terre 20 est fortement augmenté par rapport au premier point de terre 18, selon que l'impact de foudre est négatif ou positif.

En pratique, pour faciliter l'étude qu'un impact de foudre se produisant à proximité d'un système électrique a sur ce système électrique, il est possible de représenter l'onde de tension générée par un impact de foudre sous la forme d'une impulsion normalisée notée Usurge qui présente certaines caractéristiques normalisées. Par exemple, en valeur absolue, le temps de montée est égal à 1,2$\mu$s et le temps de maintien de l'impulsion à plus de 50% de la valeur de crête est supérieur à 50$\mu$s.

Dans la suite de la description, l'onde de tension appliquée entre les points de terre électrique 18 et 20 causée par l'impact de foudre 36 sera assimilé à une telle impulsion Usurge.

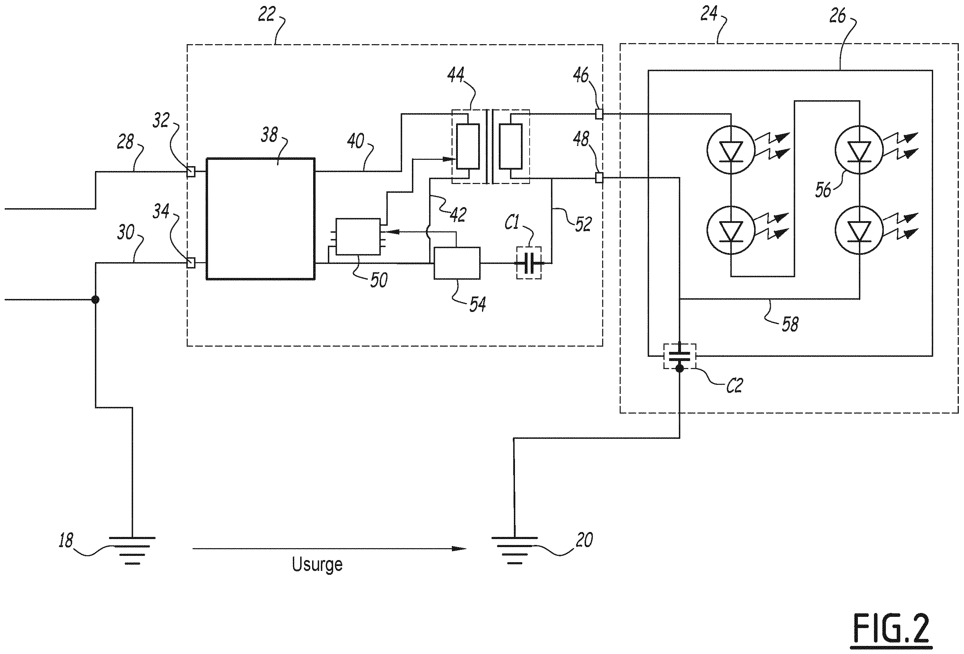

Comme visible à la figure 2, le module d'alimentation électrique 22 du lampadaire 14 comprend un redresseur 38, qui est connecté en entrée à la borne d'entrée de phase 32 et à la borne d'entrée de neutre 34. Le redresseur 38 est configuré pour filtrer et redresser le courant alternatif provenant du poste d'alimentation électrique 12 et donc pour convertir ce courant alternatif en courant continu.

En sortie du redresseur 38, un premier conducteur électrique 40 et un deuxième conducteur électrique 42 sont connectés à un convertisseur 44 de tension et de courant continu / continu, qui est raccordé à deux bornes de sortie 46 et 48 du module d'alimentation électrique 22, ici respectivement une borne positive et une borne négative.

Dans ce qui suit, à des fins d'illustration, on définit sur l'installation d'éclairage public un circuit primaire qui correspond au circuit électrique en entrée du convertisseur 44 et un circuit secondaire qui correspond au circuit électrique en sortie du convertisseur 44. Les circuits primaire et secondaire sont isolés galvaniquement par le convertisseur 44.

En pratique, le redresseur 38 et le convertisseur 44 forment ensemble un convertisseur de tension et de courant alternatif / continu isolé galvaniquement.

Le module d'alimentation électrique 22 n'ayant pas de raccordement électrique direct d'une part, et possédant d'autre part une isolation galvanique entre son circuit primaire et son circuit secondaire, il procure à l'ensemble du lampadaire une isolation électrique de classe II, c'est-à-dire respectant les critères de la classe de protection électrique II telle que définie par la Commission Électrotechnique Internationale.

Le module 22 comporte un circuit électronique de contrôle 50 configuré pour piloter le convertisseur 44. Par exemple, le circuit électronique de contrôle 50 réalise les fonctions de contrôle-commande permettant de réguler l'énergie délivrée en sortie du module d'alimentation 22.

Le circuit de contrôle 50 peut incorporer un processeur, tel qu'un microcontrôleur programmable.

Dans l'exemple, le circuit de contrôle 50 est référencé au deuxième conducteur électrique 42.

Dans le mode préférentiel de réalisation décrit, le convertisseur 44 est un convertisseur Flyback. En variante, le convertisseur 44 est un autre type de convertisseur de tension et de courant continu / continu isolé galvaniquement.

La borne de sortie négative 48 est en outre connectée au deuxième conducteur 42 du redresseur 38 par l'intermédiaire d'un troisième conducteur électrique 52, qui forme un bras du module d'alimentation.

Le module d'alimentation électrique 22 comprend un condensateur de filtrage C1, monté sur le troisième conducteur 52 et qui permet de réduire des émissions électromagnétiques indésirables. Le condensateur de filtrage C1 permet par exemple au module d'alimentation électrique 22 de respecter les normes de compatibilité électromagnétiques (CEM). On comprend donc qu'ici, le condensateur C1 est un condensateur de protection contre les émissions électromagnétiques.

Grâce au troisième conducteur électrique 52, le condensateur de filtrage C1 est donc connecté d'une part à un point référencé au circuit primaire - le deuxième conducteur 42 du redresseur 38 - et d'autre part à un point référencé au circuit secondaire - la borne de sortie négative 48 du module 22 - du convertisseur 44.

Le module d'alimentation électrique 22 comprend un circuit de détection 54 monté en série avec le condensateur de filtrage C1 sur le troisième conducteur 52 configuré pour détecter une surtension de mode commun et communiquer avec le circuit électronique de contrôle 50.

En variante, le condensateur C1 et le circuit de détection 54 ne sont pas référencés au circuit primaire comme dans l'exemple ci-dessus mais sont référencés au circuit secondaire.

Le module d'éclairage 24 du lampadaire 14 comprend au moins une source lumineuse 56 telle qu'une diode électroluminescente. La source lumineuse 56 est raccordée à un conducteur d'alimentation 58 qui relie la borne positive 46 à la borne négative 48. En d'autres termes, la source lumineuse 56 est alimentée en courant continu par le convertisseur 44 et fait donc partie du circuit secondaire. Lorsque le module d'éclairage 24 comporte plusieurs sources lumineuses 56, elles sont toutes montées en série entre les bornes 46 et 48.

Dans de nombreux modes de réalisation, les sources lumineuses 56 sont supportées par un substrat, non-visible sur les figures, fixé sur le corps métallique 26 du lampadaire 14, par exemple par collage ou par vissage. Grâce au substrat, les sources lumineuses 56 sont électriquement isolées du corps métallique 26. Cependant, la proximité des sources lumineuses avec le corps métallique induit un couplage capacitif entre le corps métallique du lampadaire relié au point de terre électrique 20 et le conducteur d'alimentation 58 relié au circuit secondaire de l'installation d'éclairage public. Ce couplage capacitif est modélisé par un condensateur C2, monté entre le point de terre électrique du lampadaire et le conducteur d'alimentation 58, comme visible à la figure 2. En pratique, le condensateur C2 a une valeur comprise entre 10 nF et 100 nF.

Les sources lumineuses 56 étant électriquement isolées du corps métallique 26 et connectées au module d'alimentation électrique 22 qui possède une isolation électrique de classe II, elles possèdent également une isolation électrique de classe II.

Ainsi, le corps métallique 26 est électriquement connecté au deuxième point de terre électrique 20 alors que les sources lumineuses 56 et le module d'alimentation électrique 22 sont électriquement isolés de ce deuxième point de terre électrique, qui représente une terre de référence locale.

Lorsqu'un impact de foudre 36 se produit à proximité du lampadaire 14, l'impulsion Usurge entre le point de terre électrique 18 du poste d'alimentation 12 et le point de terre électrique 20 du lampadaire 14 provoque la circulation d'un courant électrique de défaut, noté Isurge, dans l'installation d'éclairage public 10. Ce courant Isurge circule dans le corps métallique 26 du lampadaire 14 vers le condensateur C2, puis circule dans le conducteur d'alimentation 58, passe par la borne de sortie négative 48 du module d'alimentation 22, puis dans le troisième conducteur 52 vers le condensateur de filtrage C1, avant de rejoindre la borne d'entrée de neutre 34 du module d'alimentation et de rejoindre le point de terre électrique 18 du poste d'alimentation 12.

En d'autres termes, une impulsion Usurge entre les points de terre électrique 18 et 20 résultant d'un évènement de surtension tel qu'un impact de foudre 36 génère un courant électrique de défaut Isurge qui s'écoule dans le circuit secondaire de l'installation d'éclairage public en rencontrant les condensateurs C1 et C2 en série.

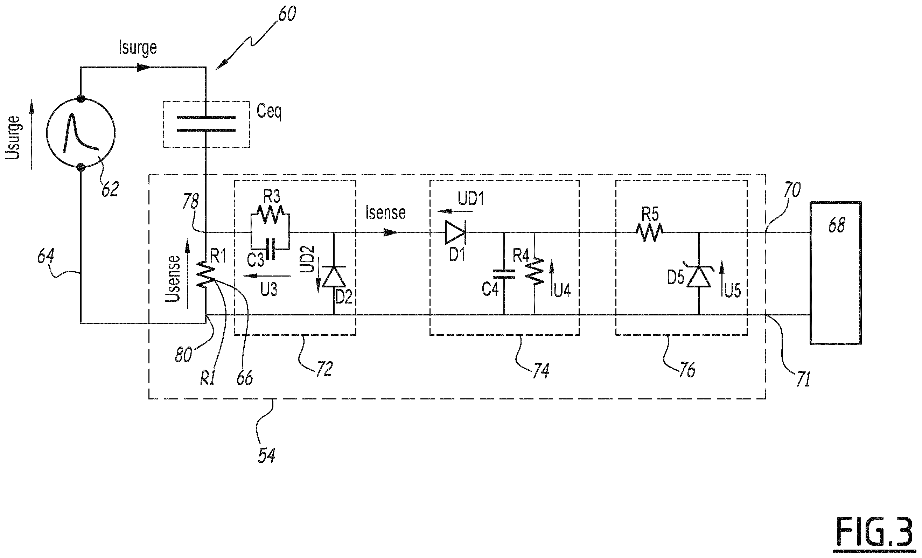

Comme visible à la figure 3, la propagation de l'impulsion Usurge dans le lampadaire 14 peut être modélisée à des fins explicatives en faisant référence à un circuit électrique équivalent 60 comprenant un générateur 62. Le générateur 62 délivre une tension impulsionnelle Usurge qui génère un courant Isurge circulant dans un bras 64 du circuit électrique 60. Les condensateurs C1 et C2 étant montés en série, ils sont équivalents à un condensateur équivalent Ceq dont la valeur est calculée par la formule suivante :

$$Ceq = \frac{C1 \times C2}{C1 + C2}$$

Le principe de l'invention est d'exploiter le courant Isurge pour détecter l'apparition d'un impact de foudre 36. Pour cela, un capteur 66 est ajouté au circuit électrique 60. Le capteur 66 est configuré pour mesurer le courant électrique Isurge circulant dans le bras 64 et délivrer une tension de mesure Usense représentative du courant Isurge. En pratique, le capteur 66 appartient au circuit de détection 54.

Dans le mode préférentiel de réalisation de l'invention décrit ici, le capteur 66 est une résistance R1. La résistance R1 est raccordée en série avec le condensateur équivalent Ceq, de sorte que la tension de mesure Usense représentative du courant Isurge circulant dans le bras 64 soit délivrée aux bornes de la résistance R1. En pratique, cela signifie que la résistance R1 doit être placée sur le circuit électrique équivalent 60 ou à tout autre endroit du module d'alimentation 22 ou même du lampadaire 14 qui partage une référence commune avec le circuit électronique de contrôle 50.

La valeur de la résistance R1 est faible, afin de ne pas dégrader le fonctionnement du module d'alimentation électrique 22, et plus particulièrement ne pas perturber la fonction de protection contre les émissions électromagnétiques du condensateur de filtrage C1. En pratique, la résistance R1 a une valeur comprise entre 0,1 $\Omega$ et 10 $\Omega$, de préférence égale à 1 $\Omega$.

Selon une variante de l'invention non illustrée sur les figures, le capteur 66 peut être implémenté par tout autre moyen électronique configuré pour mesurer le courant électrique Isurge et délivrer la tension de mesure Usense Par exemple, il s'agit d'un transformateur de courant. Utiliser un transformateur de courant pour mesurer le courant Isurge circulant dans le bras 64 permet de s'affranchir de certaines contraintes pesant sur le positionnement de la résistance R1 au sein du module d'alimentation électrique 22.

En pratique, la résistance R1 est installée sur le troisième conducteur 52 du module d'alimentation électrique 22 en série avec le condensateur C1 et appartient au circuit de détection 54, comme représenté à la figure 3.

La tension de mesure Usense délivrée par le capteur 66 est ensuite traitée par plusieurs étages de traitement du circuit de détection 54 avant d'atteindre un compteur 68, connecté aux bornes de sortie 70 et 71 du circuit de détection 54. Le traitement effectué sur ces étages est ici analogique. Ces étages de traitement sont configurés pour modifier la tension de mesure Usense afin de la rendre plus adaptée à être analysée par le compteur 68. Notamment, ils permettent de redresser la tension de mesure Usense, c'est-à-dire de fournir une tension toujours positive au compteur 68. Ces étages permettent aussi de lisser ladite tension, c'est-à-dire de fournir une tension impulsionnelle dont la décharge est plus lente que la décharge de la tension Usense. Ces étages permettent aussi de stabiliser ladite tension, c'est-à-dire de fournir une tension d'amplitude stable sur une partie du temps de décharge de la tension Usense.

En d'autres termes, le circuit de détection 54 est configuré pour détecter une surtension de mode commun et traiter une telle surtension afin de fournir une tension électrique plus simple à analyser par un compteur. En outre, le circuit de détection 54 est également configuré pour qu'en l'absence de surtension de mode commun, la tension fournie en sortie du circuit de détection n'incrémente pas le compteur 68. En pratique, cela signifie qu'en temps normal, c'est-à-dire en l'absence de surtension de mode commun, la tension fournie est soit nulle, soit inférieure à un seuil de détection du compteur.

Pour cela, le circuit de détection 54 comprend ici trois étages de traitement :

- un étage de redressement 72, qui permet de délivrer une tension positive dans le cas d'une surtension Usurge positive comme dans le cas d'une surtension Usurge négative ;
- un étage de lissage 74, qui permet de fournir une tension dont la décharge est plus lente que la décharge de la tension Usense ; et
- un étage d'écrêtage 76, qui permet de fournir une tension dont l'amplitude est stable sur une partie du temps de décharge de la tension Usense.

L'étage de redressement 72 est connecté aux bornes du capteur 66. L'étage de lissage 74 est connecté aux bornes de l'étage de redressement72. L'étage d'écrêtage 76 est connecté aux bornes de l'étage de lissage 74. Enfin, le compteur 68 est connecté aux bornes de l'étage d'écrêtage 76.

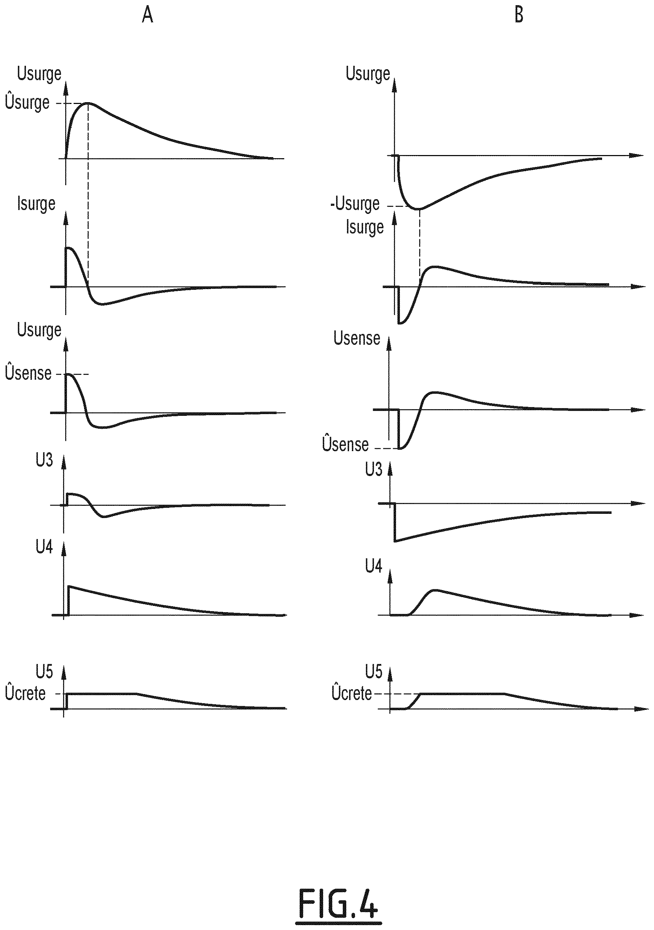

La figure 4 illustre l'évolution au cours du temps - représenté sur l'axe des abscisses - de plusieurs grandeurs électriques du circuit électrique 60, et permet de comprendre le rôle de chaque élément du circuit électrique dans le traitement de la surtension de mode commun Usurge.

Comme visible sur la figure 4, le courant Isurge créé par la surtension Usurge a la forme d'une impulsion amortie, notamment du fait des caractéristiques du circuit 60. Cette impulsion de courant Isurge atteint immédiatement une amplitude maximale, qui peut être de signe positif ou négatif. Cette impulsion de courant Isurge diminue ensuite, jusqu'à changer de signe, puis s'atténuer jusqu'à devenir nulle. Le changement de signe de Isurge se produit lorsque la surtension Usurge atteint sa valeur de crête, notée Ûsurge, comme visible sur la figure 4.

La tension Usense est ici une impulsion dont la forme, mesurée aux bornes du capteur 66, est identique à la forme du courant Isurge. La tension Usense est donc en pratique soit positive en début d'impulsion puis négative en fin d'impulsion, lorsque Usurge est positive, soit négative en début d'impulsion puis positive en fin d'impulsion, lorsque Usurge est négative.

Pour simplifier la suite de la description, on dira que la tension Usense est positive lorsque Usurge est positive, et que la tension Usense est négative lorsque Usurge est négative. On associera donc le signe de la tension impulsionnelle Usense au signe de sa valeur de crête Ûsense.

Les courbes représentées sur l'insert a) de la figure 4 correspondent à une impulsion Usense positive et les courbes représentées sur l'insert b) de la figure 4 correspondent à une impulsion Usense négative.

On note par la référence « 78 » une première borne d'entrée du capteur 66 et par la référence « 80 » une seconde borne d'entrée du capteur 66.

- L'étage de redressement 72 comprend :

  ◦ une résistance R3 montée en série entre la première borne d'entrée 78 du capteur 66 et la sortie de l'étage de redressement 72 ;
  ◦ un condensateur C3 monté en parallèle de la résistance R3 ; et
  ◦ une diode D2 montée en parallèle de la sortie de l'étage de redressement 72. La cathode de la diode D2 est reliée à la sortie de l'étage de redressement 72 et l'anode de la diode D2 est reliée à la seconde borne d'entrée 80 du capteur 66.

- L'étage de lissage 74 comprend :

  ◦ une diode D1 montée en série entre la sortie de l'étage de redressement 72 et la sortie de l'étage de lissage 74. L'anode de la diode D1 est reliée à la sortie de l'étage 72 et la cathode de D1 est reliée à la sortie de l'étage 74.
  ◦ un condensateur C4 monté en parallèle de la sortie de l'étage de lissage 74. Une première borne du condensateur C4 est reliée à la cathode de la diode D1 et une seconde borne du condensateur C4 est reliée à la seconde borne d'entrée 80 du capteur 66 ; et
  ◦ une résistance R4 montée en parallèle avec le condensateur C4.

- L'étage d'écrêtage 76 comprend :

  ◦ une résistance R5 montée en série entre la sortie de l'étage 74 et la première borne 70 de sortie du circuit de détection 54 ; et
  ◦ une diode Zener D5 montée en parallèle avec la sortie du circuit de détection 54 et en parallèle avec le compteur 68. La cathode de la diode D5 est reliée à la première borne 70 de sortie du circuit de détection 54 et l'anode de la diode D5 est reliée à la seconde borne 71 de sortie du circuit de détection 54.

On comprend que cet exemple est donné à des fins d'explication et qu'en variante, d'autres implémentations sont possibles

Dans le cas où la tension impulsionnelle Usense est positive, la diode D1 est passante et la diode D2 est bloquante. Ainsi, un courant impulsionnel Isense généré par la tension Usense et qui circule dans le circuit de détection 54 charge les condensateurs C3 et C4, qui fournissent alors respectivement une tension de charge U3 et U4. En négligeant la tension aux bornes de la diode D1, la valeur de crête Ûsense de la tension impulsionnelle Usense est répartie entre les tensions de charge U3 et U4 de façon inversement proportionnelle aux capacités des condensateurs C3 et C4. En d'autres termes, plus la capacité du condensateur C3 est importante par rapport à la capacité du condensateur C4, plus la tension U4 sera grande par rapport à la tension U3.

En pratique, la capacité du condensateur C3 est de préférence entre 10 et 500 fois plus grande que la capacité du condensateur C4, de préférence encore 25 fois supérieure. Lorsque la capacité du condensateur C3 est 25 fois supérieure à la capacité du condensateur C4, la charge impulsionnelle du courant Isense se répartit à environ 97% dans le condensateur C4. Dans une telle configuration, c'est-à-dire lorsque la tension impulsionnelle Usense est positive, l'étage de redressement 72 a un très faible effet dans le circuit de détection 54.

Une fois le condensateur C4 chargé par le courant impulsionnel Isense, et que la tension impulsionnelle Usense redescend, le condensateur C4 est déchargé par la résistance R4. La diode D1 empêche la décharge du condensateur C4 vers l'étage de redressement 72 et le capteur 66, et donc vers le reste du module d'alimentation 22.

En outre, la décharge du condensateur C4 est plus lente que la redescente du courant impulsionnel Isurge, et ce temps de décharge dépend de la résistance R4. Le choix de la valeur de la résistance R4 permet ainsi de régler le temps de décharge de C4, de manière à ce que le condensateur C4 délivre une tension sur une durée plus grande que la durée de redescente de la tension Usense, ce qui facilite le traitement effectué par le compteur 68

La tension U4 aux bornes du condensateur C4 est ensuite traitée par l'étage d'écrêtage 76.

Grâce à la résistance R5 et à la diode Zener D5, l'étage d'écrêtage 76 délivre une tension de sortie U5 écrêtée à partir de la tension U4, c'est-à-dire qu'une partie de l'amplitude du signal de U4 est supprimé. En particulier, l'étage 76 écrête toute amplitude supérieure à un seuil Ûcrete, de sorte que l'amplitude du signal U5 ne dépasse pas le seuil Ûcrete. Cet écrêtage est avantageux car il permet de fournir au capteur 66 une tension redressée, dont l'amplitude est adaptée aux niveaux de tensions admissibles par le capteur.

Dans le cas où la tension impulsionnelle Usense est négative, la diode D1 est bloquante et la diode D2 est passante. Entre le début de l'impulsion Usense et l'atteinte de la valeur de crête -Ûsense, le courant impulsionnel Isense charge intégralement le condensateur C3. Lorsque la tension impulsionnelle décroit de la valeur de crête -Ûsense à une valeur nulle, le condensateur C3 étant chargé, la diode D2 devient bloquante et la diode D1 devient passante. Le condensateur C3 va ainsi se décharger et charger le condensateur C4. Un courant additionnel I'sense, généré par la décharge du condensateur C3, circule alors dans les étages de lissage et d'écrêtage de la même manière que le courant Isense décrit précédemment pour une tension impulsionnelle Usense positive, *mutatis mutandis.*

Ainsi, l'étage de redressement 72 permet de fournir à l'étage de lissage 74 puis à l'étage d'écrêtage 76 une tension positive, que la tension impulsionnelle Usense soit positive ou négative, ce qui facilite le traitement effectué par le compteur 68.

Considérés dans leur ensemble, les trois étages de traitement du circuit de détection 54 délivrent une tension U5 simple à analyser par le compteur 68 à partir du courant Isurge provoqué par un impact de foudre 36. Le compteur 68 est ainsi configuré pour analyser la tension U5 et détecter un impact de foudre se produisant à proximité du lampadaire 14.

On comprend que, en l'absence d'impact de foudre 36, c'est-à-dire en l'absence de surtension Usurge et de courant de défaut Isurge, le circuit 54 ne délivre aucune tension U5 en sortie, et le compteur 68 n'est pas incrémenté. En pratique, au cours de l'utilisation normale du module d'alimentation électrique 22, c'est-à-dire dans le cadre de l'alimentation d'un lampadaire 14, une tension U5 n'est délivrée que lorsqu'un impact de foudre se produit au voisinage du lampadaire. La tension U5 est donc un signal de tension de courte durée, dont un exemple de profil est visible à la figure 4.

À chaque fois qu'un impact de foudre 36 est détecté par le compteur 68, un signal est envoyé au circuit électronique de contrôle 50. Ce circuit électronique de contrôle 50 stocke et remonte l'information du nombre d'évènements de surtension de mode commun détectés, en étant par exemple configuré pour envoyer un signal d'alerte à l'exploitant de l'installation d'éclairage public 10 lorsqu'un seuil prédéfini de nombre d'impact de foudre est atteint, ou pour indiquer le nombre d'impacts de foudre subis, soit périodiquement, soit à chaque fois que l'exploitant souhaite connaître cette information, par exemple lors de chaque opération de maintenance du lampadaire 14 ou lors d'un diagnostic.

Le compteur 68 peut comporter un circuit électronique, de préférence analogique. Mais en variante il peut être incorporé dans le circuit électronique de contrôle 50, voire être implémentée par un processeur du circuit 50.

Selon des exemples, pour envoyer une information, le circuit 50 peut comporter une interface de communication, telle qu'une interface de communication radio. Le circuit 50 peut en variante être couplé à une liaison de communication filaire, telle qu'un bus DALI - « Digital Addressable Lighting Interface » en anglais - utilisé pour commander le lampadaire à distance

Les composants électroniques sont configurés pour pouvoir détecter une surtension Usurge causée par un impact de foudre, c'est-à-dire que l'amplitude minimale de la surtension Ûsurge détectable est inférieure à l'amplitude générée par un impact de foudre 36. En pratique, une surtension de mode commun Usurge sera détectée pour une valeur de crête Ûsurge supérieure à 600 V environ et inférieure à -800 V environ lorsque les valeurs suivantes des composants sont choisies, données de façon non limitative et à des fins d'illustration :

- les capacités des condensateurs C1, C2 et C3 sont respectivement de 4,7 nF ; 100 nF et 3,3 nF ;
- les valeurs des résistances R1, R3, R4 et R5 sont respectivement de 1,35 Ω ; 3,9 kΩ ; 56 kΩ et R5 = 24 kΩ ;
- les diodes D1 et D2 ont chacune une tension de chute à l'état passant égale 0,6 V ; et
- la diode Zener D5 a un seuil de 2,7 V ce qui permet, en combinaison avec la résistance R5, un écrêtage de la tension U4 dans la plage [0,6 V ; 2,7 V].

Le seuil d'interprétation du compteur 68 conduisant à détecter une surtension de mode commun et donc à incrémenter le compteur est par exemple de 1,6V. Ainsi, toute tension U5 inférieure à ce seuil, par exemple dans un cas de fonctionnement normal de l'installation 10, c'est-à-dire en l'absence de surtension de mode commun, n'incrémentera pas le compteur 68.

Ces valeurs sont données à titres indicatif uniquement et sont modifiables en fonction de la mise en oeuvre du circuit de détection et des seuils de détection souhaités. Elles ne constituent pas des caractéristiques obligatoires de l'invention.

La description qui précède fournit une indication précise des composants électroniques utilisés dans le circuit de détection 54, pour la clarté de l'exposé. En pratique, le principe de détection d'impact de foudre décrit peut être mis en oeuvre de manière différente, avec par exemple l'utilisation de composants électroniques différents fournissant des fonctions similaires.

Le circuit de détection 54 et le compteur 68 présentent l'avantage d'être compacts et de n'utiliser que des composants électroniques peu onéreux. Ainsi, il est facile d'intégrer le circuit de détection 54 à une installation d'éclairage public 10, car un module d'alimentation électrique 22 contenant le circuit de détection et le compteur ne sera pas plus encombrant, ni significativement plus cher, qu'un module d'alimentation électrique dépourvu de ces éléments. En outre, le circuit de détection s'appuie sur les composants déjà existants du module d'alimentation électrique 22 pour communiquer, comme par exemple sur le circuit électronique de contrôle 50, ce qui est économe. Enfin, la présence du circuit de détection n'a pas d'impact sur le fonctionnement normal du module d'alimentation 22. Il est donc simple et pratique de mettre en oeuvre cette méthode de détection des surtensions de mode commun.

Le circuit de détection 54 étant ici analogique, son fonctionnement est fiable et ne dépend pas d'éléments externes, tels qu'une source d'alimentation dédiée ou un contrôleur.

Un autre avantage de cette méthode de détection est de permettre la détection d'impact de foudre sans nécessiter de raccordement à la terre spécifique, car la méthode de détection s'appuie sur le raccordement existant à la terre du lampadaire 14.

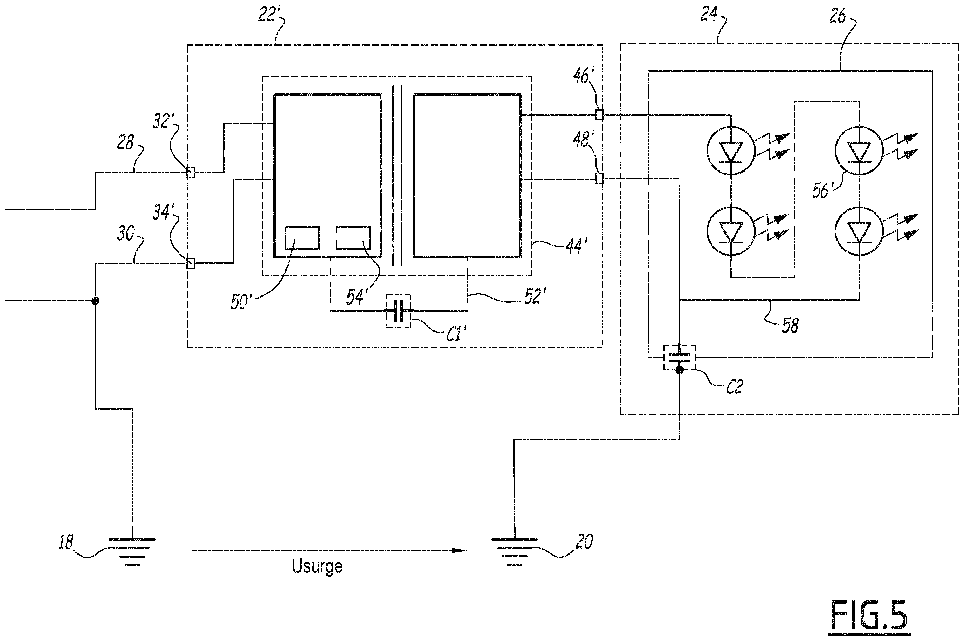

À la figure 5, un schéma des circuits électriques d'une deuxième installation électrique sont représentés, correspondant à une deuxième représentation.

Sur ce schéma, il est fait référence aux éléments identiques à ceux déjà introduits ci-dessus en utilisant les mêmes références que ci-dessus.

Sur ce schéma, il est fait référence aux éléments analogues à ceux déjà introduits mais qui diffèrent de la description donnée ci-dessus en utilisant les références ci-dessus suivies de « ' ».

Dans cette deuxième installation électrique, le module d'alimentation 22' comprend un convertisseur 44' qui est connecté d'une part aux bornes d'entrées 32' et 34' du module d'alimentation et d'autre part aux bornes de sortie 46' et 48' du module d'alimentation.

Le convertisseur 44' est donc un convertisseur de tension et de courant alternatif / continu.

Le convertisseur 44' intègre donc les fonctions du redresseur 38 et du convertisseur 44 de la première installation électrique des figures 1 à 4.

En outre, le convertisseur 44' isole galvaniquement les bornes d'entrée 32' et 34' d'une part et les bornes de sortie 46' et 48' d'autre part.

Ainsi, le module d'alimentation électrique 22' possède une isolation électrique de classe II.

On définit donc au sein du convertisseur 44' un circuit primaire, qui correspond au circuit relié aux bornes d'entrée 32' et 34', et un circuit secondaire, qui correspond au circuit relié aux bornes de sortie 46' et 48', le circuit primaire et le circuit secondaire étant isolés galvaniquement.

Ainsi, les sources lumineuses 56', connectées aux bornes de sortie du module d'alimentation, sont isolées des bornes d'entrée du module d'alimentation et donc du premier point de terre électrique 18.

Les sources lumineuses 56' étant en outre électriquement isolées du corps métallique 26, elles sont électriquement isolées de tout point de terre. En pratique, les sources lumineuses 56' possèdent une isolation électrique de classe II.

Dans cette représentation, le circuit de contrôle 50' et le circuit de détection 54' font partie du circuit primaire de convertisseur 44'.

En outre, le condensateur de filtrage C1 est connecté d'une part à un point référencé au circuit primaire du convertisseur 44' et d'autre part à un point référencé au circuit secondaire du convertisseur 44', grâce à un conducteur 52'

Ainsi, lorsqu'une surtension Usurge se produit, le courant Isurge circulera depuis le lampadaire 14 vers le premier point de terre électrique 18 en passant par le condensateur C1, malgré l'isolation galvanique entre le circuit primaire et le circuit secondaire du convertisseur 44'.

Le circuit de détection 54' est en outre connecté électriquement à la partie du condensateur de filtrage C1 reliée au circuit primaire.

Le circuit de détection 54 est configuré pour détecter les surtensions de mode commun générées par un impact de foudre se produisant dans le voisinage du lampadaire 14 mais en pratique, il permet également de détecter le courant induit par toute différence de potentiel entre le point de terre électrique 18 du poste d'alimentation 12 et le point de terre 20 du lampadaire 14, tant que cette différence de potentiel est de type impulsionnelle.

Par exemple, dans le cadre d'une procédure d'essai, il est possible d'isoler le lampadaire 14 du point de terre électrique 20 et d'augmenter le potentiel du lampadaire, afin de simuler une surtension de mode commun et de vérifier le bon fonctionnement du circuit de détection 54.

En variante non-représentée de l'invention, le circuit de détection 54 ne comprend pas l'étage de redressement 72. Dans une telle configuration, le compteur 68 compte uniquement les impacts de foudre positifs, c'est-à-dire lorsque la tension Usurge est positive, car le circuit de détection bloque la tension Usurge lorsqu'elle est négative. Cette variante permet de simplifier la mise en oeuvre du circuit de détection 54.

En variante non-représentée de l'invention, le module d'alimentation électrique 22 peut comporter des circuits de comptage et de détection séparés, pour compter séparément les impacts de foudre positifs et les impacts de foudre négatifs.

Selon un exemple non limitatif d'implémentation de cette variante, le circuit de détection 54 peut être modifié de manière à ne pas comporter l'étage de redressement 72 précédemment décrit. Le compteur 68 est alors configuré pour compter uniquement les impacts de foudre positifs. Un deuxième circuit de détection et un deuxième compteur, qui sont identiques ou analogues ou tout au moins fonctionnellement équivalents au circuit de détection 54 et au compteur 68, respectivement, sont alors ajoutés au module d'alimentation électrique 22. Le deuxième circuit de détection est configuré pour bloquer une tension Usurge positive et pour délivrer une tension de sortie U5 lorsque la tension Usurge est négative, de sorte que le deuxième compteur compte uniquement les impacts de foudre négatifs.

En variante non-représentée de l'invention, le circuit de détection 54 ne comprend pas l'étage de redressement 72 et l'étage de lissage 74 ne comprend pas la diode D1. Dans une telle configuration, le compteur 68 est configuré pour compter les impacts de foudre négatifs et les impacts de foudre positifs ou bien il intègre une fonction de redressage.

En variante non-représentée de l'invention, le circuit de détection 54 ne comprend pas l'étage de lissage 74. Dans une telle configuration, la diode D1 est intégrée à l'étage de redressement 72 et le compteur 68 est configuré pour détecter une tension U5 dont la décharge est plus rapide.

En variante non-représentée de l'invention, le compteur 68 transmet le nombre d'évènements de surtension de mode commun détectés à l'exploitant de l'installation d'éclairage public sans utiliser le circuit électronique de contrôle 50, par exemple de manière numérique par une communication sans fil, ou de manière analogique par un cadran visible sur le lampadaire 14

Les modes de réalisation, les représentations et les variantes envisagés ci-dessus peuvent être combinés pour créer de nouveaux modes de réalisation dans l'invention.

**Revendications**

1. Module d'alimentation électrique (22 ; 22') pour une installation d'éclairage public (10), ce module d'alimentation possédant une isolation électrique de classe II, ce module d'alimentation électrique comprenant :

    - des bornes d'entrées (32, 34 ; 32', 34') configurées pour être raccordées à un conducteur de phase (28) et un conducteur de neutre (30) provenant d'un poste d'alimentation électrique (12) raccordé à un premier point de terre électrique (18) ;
    - des bornes de sortie (46, 48 ; 46', 48') configurées pour être raccordées à un module d'éclairage (24) ;
    - un convertisseur (38, 44 ; 44') de tension et de courant alternatif / continu, raccordé entre les bornes d'entrée et les bornes de sortie du module d'alimentation, définissant un circuit primaire et un circuit secondaire isolés galvaniquement ; et
    - un condensateur (C1 ; C1') de filtrage connecté entre un point référencé au circuit primaire du convertisseur et un point référencé au circuit secondaire du convertisseur,

    l'isolation électrique de classe II du module d'alimentation électrique signifiant que le module d'alimentation électrique n'a pas de raccordement électrique direct à la terre et possède une isolation galvanique entre son circuit primaire et son circuit secondaire, **caractérisé en ce que** le module d'alimentation électrique (22 ; 22') comporte en outre :

    - un circuit de détection (54 ; 54') ; et
    - un compteur (68) connecté aux bornes de sortie (70, 71) du circuit de détection,

    le circuit de détection comportant :

    - un capteur (66) configuré pour :

        ∘ mesurer un courant électrique (Isurge) circulant, en cas de surtension de mode commun (Usurge) entre des conducteurs actifs (28, 30) d'alimentation du module d'alimentation électrique et une terre de référence locale (20) du module d'alimentation électrique, dans un bras (52 ; 52') du module d'alimentation comportant le condensateur (C1 ; C1') de filtrage ; et
        ∘ délivrer une tension de mesure (Usense) représentative du courant mesuré,

    - un étage de traitement (76) configuré pour fournir, en cas de surtension, un signal de tension (U5) électrique redressé en sortie du circuit de détection à partir de la tension de mesure ;

    le circuit de détection étant ainsi configuré pour détecter une surtension de mode commun (Usurge), le compteur étant configuré pour compter le nombre d'évènements de surtension de mode commun à partir du signal de tension électrique de sortie du circuit de détection.

2. Module d'alimentation électrique (22 ; 22') selon la revendication 1, dans lequel le capteur (66) du circuit de détection (54 ; 54') est une résistance (R1).

3. Module d'alimentation (22 ; 22') selon la revendication 2, dans lequel la résistance (R1) est connectée en série avec le condensateur (C1 ; C1') de filtrage.

4. Module d'alimentation (22 ; 22') selon la revendication 1, dans lequel le capteur (66) du circuit de détection est un transformateur de courant.

5. Module d'alimentation (22 ; 22') selon l'une quelconque des revendications précédentes, dans lequel l'étage de traitement (76) comprend :

    - une première résistance (R5) montée en série entre une première borne d'entrée (78) du capteur (66) et la première borne de sortie (70) du circuit de détection (54 ; 54') ; et
    - une première diode (D5) montée en parallèle avec le compteur (68), la première diode étant une diode Zener,

    et dans lequel les bornes de sortie (70, 71) du circuit de détection (54 ; 54') sont les bornes de la première diode.

6. Module d'alimentation (22 ; 22') selon la revendication 5, dans lequel le circuit de détection (54 ; 54') comprend un deuxième étage (74) connecté en amont de l'étage de traitement (76), le deuxième étage comprenant :

    - une deuxième diode (D1) montée en série entre la première borne d'entrée (78) du capteur (66) et la première résistance (R5), l'anode de la deuxième diode est reliée à la première borne (78) du capteur (66) et la cathode de la deuxième diode est reliée à la première résistance (R5) ;

- un premier condensateur (C4) monté en parallèle avec le capteur, une première borne du condensateur étant reliée à la cathode de la deuxième diode (D1) et une seconde borne du condensateur étant reliée à une seconde borne d'entrée (80) du capteur ; et

- une deuxième résistance (R4) montée en parallèle avec le premier condensateur,

et dans lequel le deuxième étage est configuré pour transformer la tension de mesure (Usense) de sorte que la décharge d'une tension (U4) aux bornes de la deuxième résistance soit plus lente que la décharge de la tension de mesure.

**7.** Module d'alimentation (22 ; 22') selon la revendication 6, dans lequel le circuit de détection (54 ; 54') comprend un troisième étage (72) connecté en amont du deuxième étage (74), le troisième étage comprenant :

- une troisième résistance (R3) montée en série entre la première borne d'entrée (78) du capteur (66) et la sortie du troisième étage (72) ;
- un deuxième condensateur (C3) monté en parallèle de la troisième résistance ; et
- une troisième diode (D2) montée en parallèle de la sortie du troisième étage dont l'anode est reliée à la deuxième borne d'entrée (80) du capteur et la cathode est reliée à la sortie du troisième étage (72),

et dans lequel le troisième étage de redressage est configuré pour que dans le cas d'une tension de mesure (Usense) négative, la tension mesurée aux bornes de la deuxième résistance (R4) soit positive.

**8.** Module d'alimentation (22 ; 22') selon la revendication 7, dans lequel la capacité du deuxième condensateur (C3) est au moins vingt-cinq fois supérieure à la capacité du premier condensateur (C4).

**9.** Lampadaire (14) comprenant :

- au moins un module d'éclairage (24) comportant au moins une source lumineuse (56 ; 56') telle qu'une diode électroluminescente ;
- un module d'alimentation électrique (22 ; 22') alimentant en courant continu le ou chaque module d'éclairage ; et
- un corps métallique (26) contenant le ou chaque module d'éclairage et le module d'alimentation, le corps métallique étant raccordé électriquement à une terre de référence locale (20) et isolée électriquement du module d'éclairage,

dans lequel le module d'alimentation électrique est conforme à l'une quelconque des revendications 1 à 8.

**10.** Installation d'éclairage public (10) comprenant :

- un poste d'alimentation électrique (12) connecté au module d'alimentation électrique (22 ; 22') par l'intermédiaire d'un conducteur de phase (28) et d'un conducteur de neutre (30), le neutre étant connecté à une terre électrique locale (18) au niveau du poste d'alimentation électrique ; et
- au moins un lampadaire (14) selon la revendication 9,

et dans laquelle le module d'alimentation électrique de chaque lampadaire est configuré pour détecter une surtension de mode commun (Usurge) entre des conducteurs actifs (28, 30) d'alimentation du module d'alimentation électrique et le corps métallique (26) du lampadaire et compter le nombre d'évènements de surtension de mode commun.

**Patentansprüche**

**1.** Stromversorgungsmodul (22; 22') für eine öffentliche Beleuchtungsanlage (10), wobei das Stromversorgungsmodul eine elektrische Isolierung der Klasse II besitzt, dieses Stromversorgungsmodul umfassend:

- Eingangsanschlüsse (32, 34; 32', 34'), die konfiguriert sind, um an einen Phasenleiter (28) und einem Neutralleiter (30) angeschlossen zu sein, der von einer Stromversorgungsstation (12) stammt, die an einen ersten elektrischen Massepunkt (18) angeschlossen ist;
- Ausgangsanschlüsse (46, 48; 46', 48'), die konfiguriert sind, um an ein Beleuchtungsmodul (24) angeschlossen zu sein;
- einen Wechselstrom/Gleichstrom-Spannungswandler (38, 44; 44'), der zwischen den Eingangsanschlüssen und den Ausgangsanschlüssen des Stromversorgungsmoduls angeschlossen ist und einen galvanisch isolierten Primär- und Sekundärstromkreis definiert; und
- einen Filterkondensator (C1; C1'), der zwischen einem auf die Primärschaltung des Umrichters bezogenen Punkt und einem auf die Sekundärschaltung des Umrichters bezogenen Punkt verbunden ist,

wobei die elektrische Isolierung der Klasse II des Stromversorgungsmoduls bedeutet, dass das Stromversorgungsmodul keinen direkten elektrischen Anschluss mit Masse aufweist und eine galvanische Isolation zwischen seinem Primärstromkreis und seinem Sekundärstromkreis besitzt,

**dadurch gekennzeichnet, dass** das Stromversorgungsmodul (22; 22') ferner Folgendes umfasst:

- eine Erfassungsschaltung (54; 54'); und
- einen Zähler (68), der an den Ausgangsanschlüssen (70, 71) der Erfassungsschaltung angeschlossen ist, die Erfassungsschaltung umfassend:
- einen Sensor (66), der zu Folgendem konfiguriert ist:

o Messen eines elektrischen Stroms (Isurge), der im Fall einer Gleichtaktüberspannung (Usurge) zwischen spannungsführenden Stromversorgungsleitern (28, 30) des Stromversorgungsmoduls und einer lokalen Bezugsmasse (20) des Stromversorgungsmoduls in einem Arm (52; 52') des Stromversorgungsmoduls, der den Filterkondensator (C1; C1') enthält, fließt; und
o Zuführen einer Messspannung (Usense), die repräsentativ für den gemessenen Strom ist,

- wobei eine Verarbeitungsstufe (76), konfiguriert ist, um im Fall einer Überspannung ein gleichgerichtetes elektrisches Spannungssignal (U5) an dem Ausgang der Erfassungsschaltung ausgehend von der Messspannung bereitzustellen;

wobei die Erfassungsschaltung somit konfiguriert ist, um eine Gleichtaktüberspannung (Usurge) zu erfassen, wobei der Zähler konfiguriert ist, um die Anzahl der Gleichtaktüberspannungsereignisse aus dem elektrischen Ausgangsspannungssignal der Erfassungsschaltung zu zählen.

2. Stromversorgungsmodul (22; 22') nach Anspruch 1, wobei der Sensor (66) der Erfassungsschaltung (54; 54') ein Widerstand (R1) ist.

3. Stromversorgungsmodul (22; 22') nach Anspruch 2, wobei der Widerstand (R1) mit dem Filterkondensator (C1; C1') in Reihe geschaltet ist.

4. Stromversorgungsmodul (22; 22') nach Anspruch 1, wobei der Sensor (66) der Erfassungsschaltung ein Stromwandler ist.

5. System (22; 22') nach einem der vorherigen Ansprüche, wobei die Verarbeitungsstufe (76) Folgendes umfasst:

- einen ersten Widerstand (R5), der zwischen einem ersten Eingangsanschluss (78) des Sensors (66) und dem ersten Ausgangsanschluss (70) der Erfassungsschaltung (54; 54') in Reihe montiert ist; und
- eine erste Diode (D5), die parallel zu dem Zähler (68) montiert ist, wobei die erste Diode eine Zenerdiode ist,

und wobei die Ausgangsanschlüsse (70, 71) der Erfassungsschaltung (54; 54') die Anschlüsse der ersten Diode sind.

6. Versorgungsmodul (22; 22') nach Anspruch 5, wobei die Erfassungsschaltung (54; 54') eine zweite Stufe (74) umfasst, die stromaufwärts von der Verarbeitungsstufe (76) verbunden ist, wobei die zweite Stufe Folgendes umfasst:

- eine zweite Diode (D1), die zwischen dem ersten Eingangsanschluss (78) des Sensors (66) und dem ersten Widerstand (R5) in Reihe montiert ist, wobei die Anode der zweiten Diode mit dem ersten Anschluss (78) des Sensors (66) verbunden ist und die Kathode der zweiten Diode mit dem ersten Widerstand (R5) verbunden ist;
- einen ersten Kondensator (C4), der parallel zu dem Sensor montiert ist, wobei ein erster Anschluss des Kondensators mit der Kathode der zweiten Diode (D1) verbunden ist und ein zweiter Anschluss des Kondensators mit einem zweiten Eingangsanschluss (80) des Sensors verbunden ist; und
- einen zweiten Widerstand (R4), der parallel zu dem ersten Kondensator montiert ist,

und wobei die zweite Stufe konfiguriert ist, um die Messspannung (Usense) derart zu transformieren, dass die Entladung einer Spannung (U4) an den Anschlüssen des zweiten Widerstands langsamer ist als die Entladung der Messspannung.

7. Stromversorgungsmodul (22; 22') nach Anspruch 6, wobei die Erfassungsschaltung (54; 54') eine dritte Stufe (72) umfasst, die stromaufwärts von der zweiten Stufe (74) geschaltet ist, die dritte Stufe umfassend:

- einen dritten Widerstand (R3), der zwischen dem ersten Eingangsanschluss (78) des Sensors (66) und dem Ausgang der dritten Stufe (72) in Reihe montiert ist;
- einen zweiten Kondensator (C3), der parallel zu dem dritten Widerstand montiert ist; und
- eine dritte Diode (D2), die parallel zu dem Ausgang der dritten Stufe montiert ist, deren Anode mit dem zweiten Eingangsanschluss (80) des Sensors verbunden ist und deren Kathode mit dem Ausgang der dritten Stufe (72) verbunden ist,

und wobei die dritte Gleichrichterstufe konfiguriert ist, um im Fall einer negativen Messspannung (Usense) die gemessene Spannung an den Anschlüssen des zweiten Widerstands (R4) positiv ist.

8. Stromversorgungsmodul (22; 22') nach Anspruch 7, wobei die Kapazität des zweiten Kondensators (C3) mindestens fünfundzwanzigmal größer ist als die Kapazität des ersten Kondensators (C4).

9. Straßenleuchte (14) umfassend:

    - mindestens ein Beleuchtungsmodul (24), umfassend mindestens eine Lichtquelle (56; 56'), wie beispielsweise eine Leuchtdiode;
    - ein Stromversorgungsmodul (22; 22'), das das oder jedes Beleuchtungsmodul mit Gleichstrom versorgt; und
    - einen Metallkörper (26), der das oder jedes Beleuchtungsmodul und das Stromversorgungsmodul enthält, wobei der Metallkörper elektrisch mit einer lokalen Bezugsmasse (20) verbunden und elektrisch von dem Beleuchtungsmodul isoliert ist,

    wobei das Stromversorgungsmodul einem der Ansprüche 1 bis 8 entspricht.

10. Öffentliche Beleuchtungsanlage (10), umfassend:

    - eine Stromversorgungsstation (12), die über einen Phasenleiter (28) und einen Nullleiter (30) mit dem Stromversorgungsmodul (22; 22') verbunden ist, wobei der Nullleiter mit einer lokalen elektrischen Masse (18) an der Stromversorgungsstation verbunden ist; und
    - mindestens eine Straßenleuchte (14) nach Anspruch 9, wobei:
    und wobei das Stromversorgungsmodul jeder Straßenleuchte konfiguriert ist, um eine Gleichtaktüberspannung (Usurge) zwischen spannungsführenden Stromversorgungsleitern (28, 30) des Stromversorgungsmoduls und dem Metallkörper (26) der Straßenleuchte zu erfassen und die Anzahl von Gleichtaktüberspannungsereignissen zu zählen.

**Claims**

1. A power supply module (22; 22') for a public lighting installation (10), said power supply module having Class II electrical insulation, said power supply module comprising:

    - input terminals (32, 34; 32', 34') configured to be connected to a phase conductor (28) and a neutral conductor (30) coming from a power supply station (12) connected to a first electrical earth point (18); output terminals (46, 48; 46', 48') configured to be connected to a lighting module (24);
    - an AC/DC voltage and current converter (38, 44; 44'), connected between the input terminals and the output terminals of the power supply module, defining a galvanically isolated primary circuit and a galvanically isolated secondary circuit; and
    - a filter capacitor (C1; C1') connected between a point referenced to the primary circuit of the converter and a point referenced to the secondary circuit of the converter,
    class II electrical isolation of the power supply module means that the power supply module has no direct electrical connection to earth and has galvanic isolation between its primary and secondary circuits,
    **characterised in that** the power supply module (22; 22') further comprises:

    - a detection circuit (54; 54'); and
    - a counter (68) connected to the output terminals (70, 71) of the detection circuit, the detection circuit comprising:
    - a sensor (66) configured to:

        ○ measure an electric current (Isurge) flowing, in the event of a common mode overvoltage (Usurge) between active power supply conductors (28, 30) of the power supply module and a local reference earth of the power supply module, in an arm (52; 52') of the power supply module comprising the filter capacitor (C1; C1'); and
        ○ deliver a measurement voltage (Usense) representative of the measured current, - a processing stage (76) configured to supply, in the event of overvoltage, a rectified electrical voltage signal (U5) at the output of the detection circuit based on the measurement voltage;

    the detection circuit thus being configured to detect a common mode overvoltage (Usurge), the counter being configured to count the number of common mode overvoltage events based on the output voltage signal of the detection circuit.

2. The power supply module (22; 22') according to claim 1, wherein the sensor (66) of the detection circuit (54; 54') is a resistor (R1).

3. The power supply module (22; 22') according to claim 2, wherein the resistor (R1) is connected in series with the filter capacitor (C1; C1').

4. The power supply module (22; 22') according to claim 1, wherein the sensor (66) of the detection circuit is a current transformer.

5. The power supply module (22; 22') according to any one of the preceding claims, wherein the pneumatic distribution system (76) comprises:

   - a first resistor (R5) connected in series between a first input terminal (78) of the sensor (66) and the first output terminal (70) of the detection circuit (54; 54'); and
   - a first diode (D5) connected in parallel with the counter (68), the first diode being a Zener diode,

   and wherein the output terminals (70, 71) of the detection circuit (54; 54') are the terminals of the first diode.

6. The power supply module (22; 22') according to claim 5, wherein the detection circuit (54; 54') comprises a second stage (74) connected upstream of the processing stage (76), the second stage comprising:

   - a second diode (D1) connected in series between the first input terminal (78) of the sensor (66) and the first resistor (R5), the anode of the second diode is connected to the first terminal (78) of the sensor (66) and the cathode of the second diode is connected to the first resistor (R5);
   - a first capacitor (C4) connected in parallel with the sensor, a first terminal of the capacitor being connected to the cathode of the second diode (D1) and a second terminal of the capacitor being connected to a second input terminal (80) of the sensor; and
   - a second resistor (R4) connected in parallel with the first capacitor,

   and wherein the second stage is configured to transform the measurement voltage (Usense) so that the discharge of a voltage (U4) across the second resistor is slower than the discharge of the measurement voltage.

7. The power supply module (22; 22') according to claim 6, wherein the detection circuit (54; 54') comprises a second stage (72) connected upstream of the second stage (74), the third stage comprising:

   - a third resistor (R3) connected in series between the first input terminal (78) of the sensor (66) and the output of the third stage (72);
   - a second capacitor (C3) connected in parallel with the third resistor; and
   - a third diode (D2) connected in parallel with the output of the third stage, the anode of which is connected to the second input terminal (80) of the sensor and the cathode of which is connected to the output of the third stage (72),

   and in which the third rectifier stage is configured so that in the case of a negative measurement voltage (Usense), the voltage measured across the second resistor (R4) is positive.

8. The power supply module (22; 22') according to claim 7, wherein the capacitance of the second capacitor (C3) is at least twenty-five times greater than the capacitance of the first capacitor (C4).

9. A lamp (14) comprising:

   - at least one lighting module (24) comprising at least one light source (56; 56') such as a light-emitting diode;
   - a power supply module (22; 22') supplying DC power to the or each lighting module; and
   - a metal body (26) containing the or each lighting module and the power supply module, the metal body being electrically connected to a local reference earth (20) and electrically insulated from the lighting module,

   wherein the power supply module is in accordance with any of claims 1 to 8.

10. A public lighting installation (10) comprising:

   - a power supply station (12) connected to the power supply module (22; 22') via a phase conductor (28) and a neutral conductor (30), the neutral being connected to a local electrical earth (18) at the power supply station; and
   - at least one lamp (14) according to claim 9,

   and wherein the power supply module of each lamp is configured to detect a common mode overvoltage (Usurge) between active supply conductors (28, 30) of the power supply module and the metal body (26) of the lamp post and to count the number of common mode overvoltage events.

EP 4 015 901 B1

FIG.1

FIG.2

EP 4 015 901 B1

EP 4 015 901 B1

FIG.3

A            B

FIG.4

FIG.5

**EP 4 015 901 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015149210 A
- CN 202797953 U